# FASCICULE DE BREVET EUROPEEN

(11) **EP 2 531 640 B1**
(45) Date de publication et mention de la délivrance du brevet: **21.11.2018**
(21) Numéro de dépôt: 11708527.4
(22) Date de dépôt: 02.02.2011
(51) Int. Cl.: D03D 9/00, D03D 15/00, D03D 1/00, H01L 23/49, H01L 21/60, H01L 29/06, H01L 21/98, H01L 25/065

(54) **PROCEDE D'ASSEMBLAGE D'AU MOINS UNE PUCE AVEC UN TISSU ET TISSU INCLUANT UN DISPOSITIF A PUCE**
VERFAHREN ZUM EINBAUEN VON MINDESTENS EINEM CHIP IN EINEM GEWEBE SOWIE GEWEBE MIT EINER CHIPVORRICHTUNG
METHOD FOR ASSEMBLING AT LEAST ONE CHIP ON A FABRIC, AND FABRIC INCLUDING A CHIP DEVICE

(30) Priorité: 03.02.2010 FR 1000426
(43) Date de publication de la demande: 12.12.2012
(73) Titulaire: Commissariat à l'Énergie Atomique et aux Énergies Alternatives, 75015 Paris (FR)
(72) Inventeur: VICARD, Dominique, F-38190 Bernin (FR); BRUN, Jean, F-38800 Champagnier (FR)
(74) Mandataire: Talbot, Alexandre
(86) Numéro de dépôt international: PCT/FR2011/000065
(87) Numéro de publication internationale: WO 2011/095708

(56) Documents cités:
- WO-A1-2008/025889
- WO-A2-2008/007237
- WO-A2-2008/080245
- DE-A1-102008 011 133
- US-A1- 2005 223 552
- JEAN BRUN ET AL: "Packaging and wired interconnections for insertion of miniaturized chips in smart fabrics", MICROELECTRONICS AND PACKAGING CONFERENCE, 2009. EMPC 2009. EUROPEAN, IEEE, PISCATAWAY, NJ, USA, 15 juin 2009 (2009-06-15), pages 1-5, XP031534243, ISBN: 978-1-4244-4722-0

## Description

### Domaine technique de l'invention

L'invention est relative à un dispositif incluant une puce électronique et comprenant deux rainures ouvertes sur des côtés opposés du dispositif.

### État de la technique

De nombreuses techniques existent aujourd'hui pour connecter mécaniquement et électriquement des puces microélectroniques entre elles. Une technique classique consiste, une fois les puces formées sur un substrat, et libérées par sciage, à réaliser une connexion mécanique rigide entre les puces. Les puces, alors fixées sur un support rigide, sont ensuite connectées électriquement avant qu'un enrobage de protection ne soit formé. Cette approche, consistant à réaliser la connexion sur un support rigide, est classiquement utilisée lorsqu'il existe une grande complexité dans la connexion des puces. Cependant, cette dernière a pour principal inconvénient d'utiliser un support mécanique rigide qui est particulièrement mal adapté à une intégration dans des structures souples.

Le document WO2008/025889 de la demanderesse décrit, comme l'illustre la figure 1, une puce microélectronique comportant deux faces principales parallèles 1, 2 et des faces latérales 3a, 3b reliant les faces principales 1, 2. Chacune des faces latérales 3a, 3b comporte une rainure 4, munie d'un élément de connexion électrique (non représenté), et formant un logement pour un élément filaire 5 ayant un axe parallèle à l'axe longitudinal de la rainure 4. L'élément de connexion électrique est réalisé par métallisation de la rainure 4.

L'élément filaire 5, dont l'axe est parallèle à l'axe longitudinal de la rainure 4, peut être solidarisé à la rainure 4 par soudure avec apport de matériau, par électrolyse, par collage, ou par encastrement. Ces méthodes de solidarisation sont complexes à mettre en oeuvre compte tenu de la petite taille des dispositifs à puce.

Les paires de fils ainsi munies de dispositifs à puce peuvent ensuite être tissées avec d'autres fils pour former un tissu. Ceci nécessite certaines précautions lors de la manipulation pendant le tissage, afin de ne pas arracher les dispositifs à puce. Un exemple d'un tel tissu est donné dans l'article intitulé "Packaging and wired interconnections for insertion of miniaturized chips in smart fabrics" par Jean Brun et al. daté du 15.06.2009.

### Résumé de l'invention

On cherche ainsi à incorporer de manière simple des dispositifs à puce électronique dans un tissu sans exiger de précautions lors du tissage. Pour cela, on cherche en particulier à réaliser un dispositif à puce qui puisse être incorporé de manière aisée entre deux fils tendus parallèles, appartenant notamment à un tissu fini.

On satisfait ce besoin à l'aide d'un dispositif à puce de configuration particulière. Le dispositif comprend une puce électronique et deux rainures sensiblement parallèles ouvertes sur des côtés opposés du dispositif. L'écartement des rainures correspond à l'écartement des fils. Le dispositif présente une forme pénétrante le long d'un axe perpendiculaire au plan des rainures, ayant une base au niveau des rainures et un sommet de dimension inférieure à l'écartement des fils.

Le dispositif est inséré entre les deux fils selon un procédé selon la revendication 1, le procédé comprenant les étapes consistant à positionner le sommet du dispositif entre les deux fils ; à déplacer le dispositif entre les deux fils, d'où il résulte que les fils sont écartés par la forme pénétrante du dispositif ; et à continuer le déplacement du dispositif jusqu'à ce que les fils pénètrent dans les rainures en revenant vers leur écartement initial.

On peut réaliser ainsi un tissu selon la revendication 7 comprenant un dispositif muni d'une puce électronique et de deux rainures sensiblement parallèles ouvertes sur des côtés opposés du dispositif, dans lesquelles sont insérés deux fils consécutifs sensiblement parallèles du tissu, le dispositif présentant une forme pénétrante le long d'un axe perpendiculaire au plan des rainures, ayant une base au niveau des rainures et un sommet de dimension inférieure à l'écartement des fils.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
La figure 1 illustre une puce selon l'art antérieur.
La figure 2 illustre un mode de réalisation d'un dispositif à puce.
La figure 3 illustre une vue de dessous du dispositif de la figure 2.
La figure 4 illustre en vue de dessous un autre mode de réalisation d'un dispositif à puce.
La figure 5 illustre en vue de dessous une variante du mode de réalisation de la figure 4.
La figure 6 illustre un tissu vu de dessus dans lequel sont insérés des dispositifs à puce.
Les figures 7 à 9 illustrent des étapes d'insertion d'un dispositif à puce dans un tissu.
Les figures 10 et 11 illustrent un autre mode de réalisation de dispositif à puce.

### Description de modes particuliers de réalisation

Comme on l'a précédemment indiqué, on cherche à réaliser un dispositif à puce électronique muni de rainures d'insertion de fils, qui soit facilement incorporable à un tissu. Ces dispositifs à puce seront notamment incorporables dans un tissu fini. En d'autres termes, on n'aura pas besoin de les solidariser à des fils qui servent par la suite à tisser le tissu.

En règle générale, un tissu est formé par des fils de chaîne sensiblement parallèles les uns aux autres, et par des fils de trame sensiblement parallèles les uns aux autres et croisant les fils de chaîne. Deux fils de chaîne consécutifs et deux fils de trame consécutifs forment une maille ayant le plus souvent une forme générale de parallélogramme. Bien entendu, d'autres types de tissus et mailles peuvent être envisagés.

Un dispositif à puce tel qu'exposé plus en détail ci-après comprend une partie au profil pénétrant, destinée à s'insérer dans une maille du tissu et à écarter les fils formant la maille sous une pression exercée sur le dispositif, jusqu'à ce que ces fils parviennent à la hauteur des rainures et s'y insèrent par retour élastique. Plus spécifiquement, le profil en question présente une caractéristique pénétrante le long d'un axe perpendiculaire au plan des rainures. Sa base est située au niveau des rainures et son sommet est de dimension inférieure à l'écart de deux fils consécutifs du tissu. Par « plan des rainures », on entend un plan passant au plus près des axes longitudinaux des rainures, dans le cas où les rainures ne seraient pas rigoureusement parallèles.

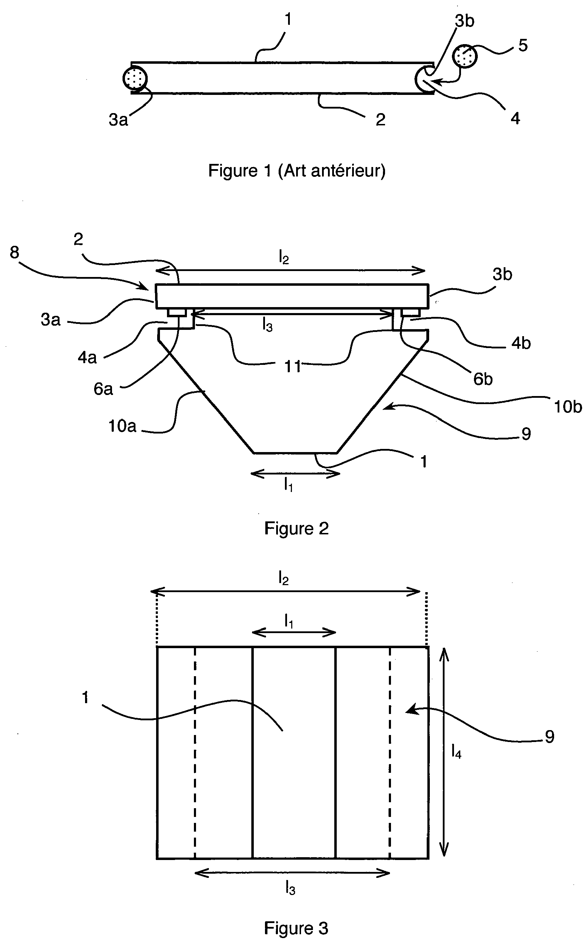

La figure 2 représente une vue de face d'un mode de réalisation de dispositif à puce incorporable dans un tissu. Des mêmes éléments qu'à la figure 1 sont désignés par des mêmes références.

Le dispositif comprend une puce électronique 8 et deux rainures 4a, 4b ouvertes sur des côtés opposés du dispositif. Dans ce mode de réalisation, les rainures sont creusées dans deux faces opposées 3a et 3b sensiblement parallèles du dispositif, et leurs axes longitudinaux sont sensiblement parallèles. Les rainures 4a et 4b sont traversantes, c'est-à-dire qu'elles débouchent sur des faces du dispositif perpendiculaires aux faces 3a et 3b.

Dans la plupart des applications, on voudra connecter la puce 8 électriquement à d'autres puces, à un bus de données, à une alimentation électrique, à une antenne... Pour cela, les rainures 4a et 4b sont munies de plots conducteurs 6a et 6b qui seront connectés aux fils insérés dans les rainures, ces fils étant alors conducteurs ou comportant des fibres conductrices. De préférence, les plots 6a et 6b sont situés sur une paroi latérale des rainures, par exemple du côté de la puce. Ainsi, chaque plot peut aussi former une pince mécanique permettant de fixer un fil entre le plot et la paroi latérale opposée de la rainure.

Le dispositif comprend une partie 9 au profil pénétrant qui, dans ce mode de réalisation, est de section trapézoïdale. La base du trapèze est raccordée aux bords des parois 3a et 3b, tandis que le sommet du trapèze forme l'une des faces principales du dispositif, par exemple la face 1. Les bords inclinés du trapèze sont désignés par 10a et 10b.

La figure 3 représente une vue de dessous du dispositif de la figure 2. Comme on l'aperçoit dans cette figure, la partie 9 est prismatique dans ce mode de réalisation. Les faces inclinées du prisme seront également désignées par 10a et 10b, comme les bords inclinés du trapèze en figure 2.

Cette forme pénétrante permet d'insérer facilement le dispositif dans un tissu fini ou partiellement fini, notamment entre deux fils consécutifs tendus, de chaîne ou de trame. Les dimensions de la face sommitale 1 du prisme sont de préférence inférieures à celles d'une maille du tissu. Il suffit alors de présenter le dispositif en orientant sa face 1, que l'on appellera ci-après «face de pénétration », en regard des deux fils consécutifs, avec les rainures 4a et 4b sensiblement parallèles aux fils, puis de faire pénétrer la face 1 entre les deux fils. Au cours de la pénétration, les fils sont écartés par les parois inclinées 10a et 10b du prisme, jusqu'à ce que les fils parviennent à la hauteur des rainures et s'y insèrent par retour élastique.

Le dispositif peut être réalisé en deux parties, à savoir une puce plane 8 sur laquelle on assemble un capot formant la partie pénétrante 9. Les rainures 4a et 4b sont alors de préférence formées à l'interface entre la puce et le capot. Dans ce mode de réalisation, le capot 9 comporte deux épaulements 11 dont les faces perpendiculaires définissent respectivement une paroi latérale des rainures et le fond des rainures. L'autre paroi latérale des rainures est définie par la puce 8.

Dans les modes de réalisation décrits ci-après, la forme pénétrante 9 du dispositif à puce est réalisée par le capot. Bien entendu, la personne du métier sera à même de structurer la puce à la place du capot pour lui donner la forme désirée. Il est aussi possible de réaliser le dispositif dans une pièce monolithique incluant une puce, en structurant convenablement la pièce monolithique.

De préférence, la dimension transversale I₁ de la face de pénétration 1 est inférieure au pas des fils du tissu, et la dimension transversale I₂ séparant les faces latérales 3a et 3b est supérieure au pas. Idéalement, le pas des fils est sensiblement égal à la distance I₃ séparant les fonds des rainures 4a et 4b.

La longueur I₄ du prisme 9, et donc de la face de pénétration 1, est égale à la longueur du dispositif. Cette longueur étant définie par la taille du dispositif, elle est plus difficilement adaptable à toute taille de maille d'un tissu. Ainsi, le mode de réalisation des figures 2 et 3 est plutôt adapté à l'incorporation dans un tissu dont les mailles sont de forme allongée dans l'axe du prisme 9.

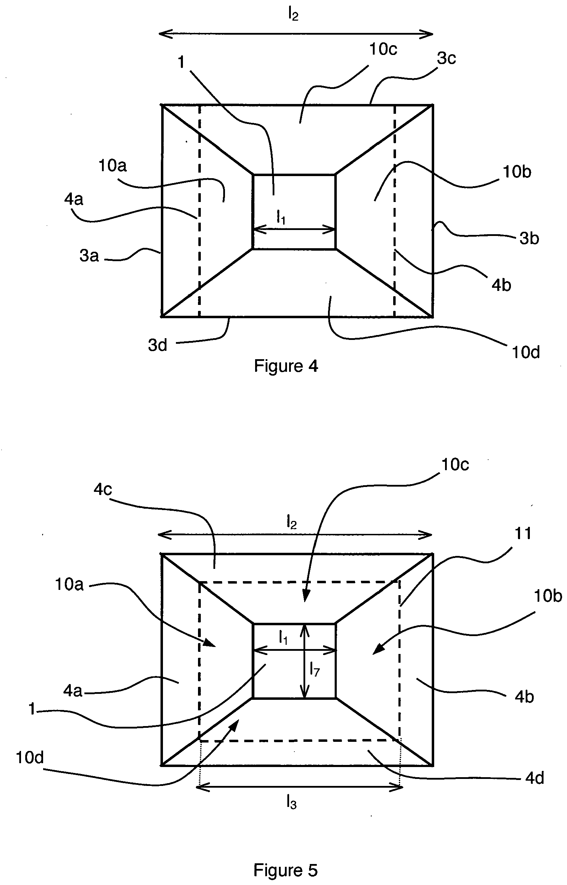

La figure 4 représente, en vue de dessous, un mode de réalisation de dispositif à puce plus adapté à une insertion dans des mailles quelconques d'un tissu fini. La vue de face, non représentée, est semblable à celle de la figure 2. Le capot 9 a une forme de pyramide dont la base délimite avec la puce 8 les rainures 4a et 4b. La pyramide sera généralement tronquée et son sommet formera ainsi la face de pénétration 1. Autrement dit, le capot 9 comporte quatre faces obliques 10a, 10b, 10c, 10d. Les faces obliques 10a et 10b relient les faces latérales opposées 3a et 3b, comportant les rainures 4a, 4b, à des côtés opposés correspondants de la face 1. Les faces obliques 10c et 10d relient les faces latérales opposées restantes 3c et 3d du dispositif à des côtés opposés correspondants de la face 1.

Les dimensions de la face de pénétration 1 peuvent ainsi être choisies indépendamment afin de les adapter à une taille de maille minimale. Cette face 1 peut être carrée, de coté aussi petit que le permet la technologie de fabrication.

La figure 5 représente, en vue de dessous, une variante du mode de réalisation de la figure 4. Les faces latérales 3c et 3d comportent également des rainures 4c et 4d de logement d'éléments filaires. Ces rainures 4c et 4d sont, comme les rainures 4a et 4b, définies par des épaulements 11 du capot 9 et une face de la puce 8, dans ce mode de réalisation. Le dispositif comporte ainsi quatre rainures disposées en rectangle, aptes à recevoir les quatre fils d'une maille de tissu.

La face de pénétration 1 a, de préférence, des dimensions transversale I₁ et longitudinale I₇ inférieures aux dimensions correspondants d'une maille du tissu dans lequel le dispositif sera inséré. Idéalement, les dimensions séparant les fonds des rainures 4a et 4b, d'une part, et les fonds des rainures 4c et 4d, d'autre part, sont sensiblement égales aux pas des fils dans les directions correspondantes (trame ou chaîne).

Un tel dispositif s'insère dans un tissu de la même manière que décrite en relation avec les figures 2 et 3. Il est présenté avec sa face de pénétration 1 tournée vers le tissu, et déplacé vers le tissu. La face 1 pénètre dans une maille, et les parois obliques 10a à 10d écartent les quatre fils formant la maille. Lorsque ces quatre fils arrivent à la hauteur des rainures 4a à 4d, ils y pénètrent par retour élastique.

Ainsi, un tel dispositif, une fois inséré dans une maille du tissu, sera maintenu par quatre fils insérés dans les rainures respectives 4a à 4d. Ceci améliore le maintien, et permet en outre d'augmenter le nombre d'interconnexions électriques possibles.

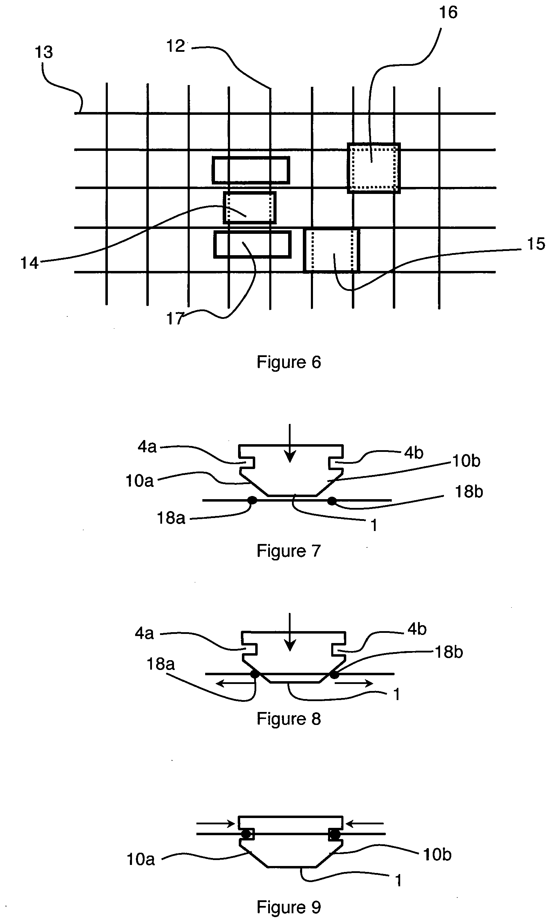

La figure 6 représente schématiquement un tissu dans lequel on a incorporé des dispositifs à puce selon les divers modes de réalisation précédemment décrits. Le tissu comprend des fils de trame 12 et des fils de chaîne 13. Les fils de trame et de chaîne ont été représentés perpendiculaires et les pas de chaîne et de trame ont été représentés sensiblement égaux, de sorte que les mailles sont carrées. Bien entendu, les orientations des fils et les pas peuvent être quelconques sans que cela n'affecte l'utilisation des dispositifs à puce décrits ici - il suffira de prévoir des dispositifs à puce de dimensions et formes adaptées au tissu particulier auquel on souhaite les incorporer.

La référence 14 désigne un dispositif à puce du type des figures 2 et 3, coopérant avec deux fils de trame 12. Comme cela est représenté, la dimension (I₄ à la figure 3) dans le sens des fils de trame de ce dispositif est de préférence inférieure au pas des fils de chaîne 13.

Les références 15 et 16 désignent respectivement des dispositifs à puce des types des figures 4 et 5.

Afin de ne pas déformer le tissu en insérant un dispositif du type comportant seulement deux rainures (14 ou 15), un fer de blocage 17 peut être reporté de part et d'autre de l'emplacement du dispositif, au niveau des faces dépourvues de rainures, de sorte que les fils consécutifs prennent appui sur ce dernier. Le fer 17 est reporté sur la face opposée à celle par laquelle le dispositif est inséré. Il peut se présenter sous la forme d'une barre dont l'axe longitudinal est perpendiculaire à l'axe longitudinal des rainures d'insertion des fils. Ainsi, la pression exercée lors de l'insertion du dispositif ne détériore pas le tissu.

Pour éviter une déformation du tissu, il est aussi possible de le pré-encoller afin de lui procurer une rigidité suffisante.

Dans le cas où on souhaite confirmer l'insertion des fils dans les rainures, notamment lorsque les fils, conducteurs, sont à pincer entre une paroi de la rainure et un plot conducteur 6a, 6b (figure 2), on peut prévoir un mors (non représenté) venant se plaquer sur les bords munis des rainures du dispositif, après l'insertion par retour élastique des fils dans les rainures. De cette manière, le mors finit d'insérer les fils dans les rainures au cas où la force élastique des fils serait insuffisante. Selon une alternative, le mors, au lieu de se plaquer contre les bords du dispositif, peut être prévu pour resserrer les fils sortant de part et d'autre du dispositif.

Les figures 7, 8 et 9 illustrent trois états dans un procédé d'insertion d'un dispositif à puce dans un tissu.

A la figure 7, le dispositif est tout d'abord orienté avec sa face de pénétration 1 vers le tissu, puis déplacé vers le tissu. Si l'on souhaite placer le dispositif à un endroit précis du tissu, par exemple entre deux fils consécutifs 18a et 18b spécifiques, ou dans une maille spécifique, la face de pénétration 1 est centrée par rapport à la maille correspondante, ou par rapport aux deux fils 18a et 18b correspondants. Dans le cas contraire, la face de pénétration 1 n'a pas besoin d'être centrée par rapport à une maille - cette face 1, plus petite qu'une maille et raccordée à des faces obliques, procurera un auto-centrage à la pénétration dans le tissu.

A la figure 8, les fils 18a et 18b sont progressivement écartés par les faces obliques 10a et 10b du dispositif au fur et à mesure que le dispositif pénètre dans le tissu.

A la figure 9, les fils 18a et 18b sont parvenus à la hauteur des rainures 4a et 4b. Par effet élastique, les fils reprennent leur position initiale et s'insèrent dans leurs rainures respectives 4a et 4b.

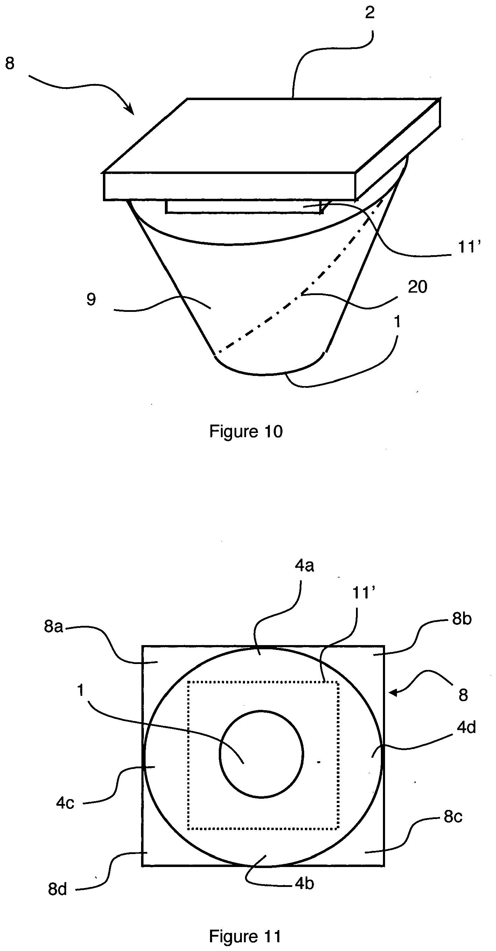

Les figures 10 et 11 représentent une vue en perspective et une vue de dessous d'un troisième mode de réalisation de dispositif à puce. Le capot 9 est formé par un cône dont la base délimite, avec la puce 8, quatre rainures périphériques 4a à 4d. Il est bien entendu possible de réaliser un dispositif à seulement deux rainures opposées (4a et 4b). Les fonds des rainures sont définis par un socle 11' rectangulaire, de préférence carré, s'étendant depuis la base du cône 9 vers la puce 8. Le cône est, de préférence, comme illustré aux figures 10 et 11, tronqué à son extrémité, délimitant ainsi la face de pénétration 1. De préférence, la puce 8 a un contour carré dans lequel s'inscrit la base du cône. Quatre coins 8a, 8b, 8c et 8d de la puce 8 font saillie par rapport à la base du cône.

Ce dispositif s'insère dans un tissu de manière similaire aux modes de réalisation précédemment décrits. Il présente en outre la particularité, si on l'insère tourné de 45°, c'est-à-dire avec les diagonales de la puce parallèles aux fils du tissu, que les coins 8a à 8d servent de butée de fin de course en venant en appui sur les fils délimitant la maille. Ensuite, il est appliqué au dispositif un huitième de tour pour aligner les rainures avec les fils, permettant aux fils de s'insérer par retour élastique dans leurs rainures respectives 4a à 4d.

Selon une variante non représentée de ce dispositif, le capot 9 en forme de cône comporte un filetage à deux filets 20 dans la surface du cône, chaque filet débouchant dans l'une de deux rainures opposées. Ce filetage permet alors une insertion du dispositif par vissage entre deux fils consécutifs. Ainsi, lors du procédé d'assemblage, les filets du filetage sont mis en prise avec deux fils consécutifs de chaîne ou de trame et la rotation du dispositif à puce sur lui-même permet de visser ce dernier dans le tissu jusqu'à ce que les fils viennent s'insérer dans les rainures. Ce mode de réalisation permet un montage plus aisé des dispositifs à puce dans un tissu très rigide.

Le dispositif à puce peut comporter une diode électroluminescente ou offrir tout autre type de fonction réalisable par la puce 8. Ainsi, en plaçant judicieusement plusieurs dispositifs dans un tissu, il est possible de réaliser des motifs précis et d'alimenter ces dispositifs par des fils électriquement conducteurs. Il est aussi possible d'insérer des dispositifs de type RFID dans un ruban tissé, les antennes desdits dispositifs étant alors réalisées par des fils électriquement conducteurs du tissu, par exemple en cuivre.

De tels dispositifs peuvent aussi être insérés dans des vêtements intelligents afin de suivre l'évolution d'une personne tant sur le plan géographique que sur le plan médical.

Les dispositifs peuvent avoir des dimensions inférieures à 5 mm de côté, l'épaisseur de la puce 8 et du capot 9 peut être inférieure à 200 µm. Les dispositifs peuvent alors être insérés dans un tissu en utilisant des machines classiques de manipulation de petits objets. Le procédé d'insertion dans un tissu peut dès lors être mis en place à faible coût.

De nombreuses variantes et modifications des modes de réalisation décrits ici apparaîtront à l'homme du métier. Par exemple, il est possible d'utiliser un élément de type entretoise entre le capot 9 et la puce 8 de sorte à maintenir ces derniers écartés et à définir les fonds des rainures. On a décrit des formes pénétrantes prismatique, pyramidale et conique, mais toute autre forme convexe peut convenir.

## Revendications

1. Procédé d'assemblage d'un dispositif sur deux fils comprenant les étapes suivantes :
• prévoir deux fils tendus (12) sensiblement parallèles ;
• prévoir un dispositif comprenant une puce électronique (8) et deux rainures (4a, 4b) sensiblement parallèles ouvertes sur des côtés opposés du dispositif, l'écartement des rainures correspondant à l'écartement des fils, ledit dispositif comprenant une partie au profil pénétrant s'étendant le long d'un axe perpendiculaire au plan des rainures, ladite partie au profil pénétrant ayant une base au niveau des rainures et un sommet (1) de dimension inférieure à l'écartement des fils ;
• placer ledit sommet (1) du dispositif entre les deux fils ;
• déplacer le dispositif entre les deux fils, d'où il résulte que les fils sont écartés par ladite partie au profil pénétrant; et
• continuer le déplacement du dispositif jusqu'à ce que lesdits fils pénètrent dans les rainures en revenant vers leur écartement initial.

2. Procédé selon la revendication 1, **caractérisé en ce que** la partie au profil pénétrant du dispositif est conique et comporte un filetage à deux filets (20) débouchant chacun dans une rainure respective (4a, 4b), le procédé comprenant les étapes suivantes :
• mettre les filets en prise avec les deux fils ; et
• appliquer un mouvement de vissage au dispositif.

3. Procédé selon la revendication 1, **caractérisé en ce qu'**une rainure du dispositif comprend un plot (6a, 6b) de connexion électrique (4a, 4b), le fil correspondant à la rainure munie du plot étant électriquement conducteur.

4. Procédé selon la revendication 1, **caractérisé en ce que** le dispositif comprend un capot (9) délimitant, avec la puce (8) électronique, les rainures (4a, 4b), ledit capot incluant ladite partie au profil pénétrant.

5. Procédé selon la revendication 4, **caractérisé en ce que** la partie au profil pénétrant du capot (9) a une forme de pyramide.

6. Procédé selon la revendication 4, **caractérisé en ce que** la partie au profil pénétrant du capot (9) a une forme de cône.

7. Tissu (12, 13) incluant un dispositif comprenant une puce électronique (8) et deux rainures (4a, 4b) sensiblement parallèles ouvertes sur des côtés opposés du dispositif, dans chacune desquelles est inséré un fil du tissu, les deux fils insérés dans lesdites rainures étant deux fils consécutifs sensiblement parallèles du tissu, le tissu étant **caractérisé en ce que** le dispositif comporte une partie au profil pénétrant qui s'étend le long d'un axe perpendiculaire au plan des rainures et qui présente une base au niveau des rainures et un sommet (1) de dimension inférieure à l'écartement des fils.

8. Tissu selon la revendication 7, **caractérisé en ce qu'**une rainure du dispositif comprend un plot (6a, 6b) de connexion électrique (4a, 4b), le fil inséré dans la rainure munie du plot étant électriquement conducteur et en contact électrique avec ledit plot.

9. Tissu selon la revendication 7, **caractérisé en ce que** le dispositif comprend un capot (9) délimitant, avec la puce (8) électronique, les rainures (4a, 4b), ledit capot incluant ladite partie au profil pénétrant.

10. Tissu selon la revendication 9, **caractérisé en ce que** la partie au profil pénétrant du capot (9) a une forme de pyramide.

11. Tissu selon la revendication 9, **caractérisé en ce que** la partie au profil pénétrant du capot (9) a une forme de cône.

12. Tissu selon la revendication 11, **caractérisé en ce que** le cône comprend un filetage à deux filets, chaque filet débouchant dans une des rainures (4a, 4b).

13. Tissu selon la revendication 8, **caractérisé en ce que** la puce électronique (8) comprend une diode électroluminescente.

14. Tissu selon la revendication 7, **caractérisé en ce que** le dispositif comprend quatre rainures (4a-4d) disposées en rectangle, dans lesquelles sont insérées quatre fils formant une maille du tissu.

## Patentansprüche

1. Verfahren zum Einbauen einer Vorrichtung an zwei Fäden, welches die folgenden Verfahrensschritte umfasst:
- es werden zwei gespannte Fäden (12), im Wesentlichen parallel, vorgesehen;
- es wird eine Vorrichtung vorgesehen, die einen elektronischen Chip (8) und zwei Rillen (4a, 4b) aufweist, welche an entgegengesetzten Seiten der Vorrichtung offen im Wesentlichen parallel angeordnet sind, wobei der Abstand zwischen den Rillen dem Abstand zwischen den Fäden entspricht, wobei diese Vorrichtung einen Teil mit eindringendem Profil aufweist, der sich entlang einer senkrecht zu der Ebene der Rillen verlaufenden Achse erstreckt, wobei dieser Teil mit eindringendem Profil eine Basis in Höhe der Rillen und eine Spitze (1), deren Abmessung geringer ist als der Abstand zwischen den Fäden, aufweist;
- diese Spitze (1) der Vorrichtung wird zwischen die beiden Fäden gebracht;
- die Vorrichtung wird zwischen den beiden Fäden verschoben, was bewirkt, dass die Fäden von diesem Teil mit eindringendem Profil auseinander gedrückt werden; und
- die Vorrichtung wird weiter verschoben, bis diese Fäden in die Rillen eindringen, wobei sie wieder in ihren ursprünglichen Abstand voneinander gelangen.

2. Verfahren nach Anspruch 1,
**dadurch gekennzeichnet,**
**dass** der Teil mit eindringendem Profil der Vorrichtung konisch ist und ein Außengewinde mit zwei Gewindegängen (20) aufweist, die jeweils in einer der Rillen (4a bzw. 4b) münden, wobei das Verfahren die folgenden Verfahrensschritte umfasst:
- die Gewindegänge werden mit den beiden Fäden in Eingriff gebracht; und
- mit der Vorrichtung wird eine Schraubbewegung vollführt.

3. Verfahren nach Anspruch 1,
**dadurch gekennzeichnet,**
**dass** eine Rille (4a bzw. 4b) der Vorrichtung einen elektrischen Anschlussklotz (6a, 6b) enthält, wobei der Faden, der mit der mit dem Klotz versehenen Rille in Kontakt ist, elektrisch leitend ist.

4. Verfahren nach Anspruch 1,
**dadurch gekennzeichnet,**
**dass** die Vorrichtung eine Kappe (9) aufweist, die zusammen mit dem elektronischen Chip (8) die Rillen (4a, 4b) abgrenzt, wobei diese Kappe den genannten Teil mit eindringendem Profil einschließt.

5. Verfahren nach Anspruch 4,
**dadurch gekennzeichnet,**
**dass** der Teil mit eindringendem Profil der Kappe (9) pyramidenförmig gestaltet ist.

6. Verfahren nach Anspruch 4,
**dadurch gekennzeichnet,**
**dass** der Teil mit eindringendem Profil der Kappe (9) eine konusförmig gestaltet ist.

7. Gewebe (12, 13), welches eine Vorrichtung umschließt, die einen elektronischen Chip (8) und zwei Rillen (4a, 4b) aufweist, welche an entgegengesetzten Seiten der Vorrichtung offen im Wesentlichen parallel angeordnet sind und in denen jeweils ein Gewebefaden sitzt, wobei die beiden in diesen Rillen sitzenden Fäden zwei im Wesentlichen parallele aufeinanderfolgende Fäden des Gewebes sind,
**dadurch gekennzeichnet,**
**dass** die Vorrichtung einen Teil mit eindringendem Profil aufweist, der sich entlang einer senkrecht zu der Ebene der Rillen verlaufenden Achse erstreckt, und der eine Basis in Höhe der Rillen und eine Spitze (1), deren Abmessung geringer ist als der Abstand zwischen den Fäden, aufweist.

8. Gewebe nach Anspruch 7,
**dadurch gekennzeichnet,**
**dass** eine Rille (4a bzw. 4b) der Vorrichtung einen elektrischen Anschlussklotz (6a, 6b) enthält, wobei der Faden, der in der mit dem Klotz versehenen Rille eingesetzt ist, elektrisch leitend ist und sich in elektrischem Kontakt mit diesem Klotz befindet.

9. Gewebe nach Anspruch 7,
**dadurch gekennzeichnet,**
**dass** die Vorrichtung eine Kappe (9) aufweist, die zusammen mit dem elektronischen Chip (8) die Rillen (4a, 4b) abgrenzt, wobei diese Kappe den genannten Teil mit eindringendem Profil einschließt.

10. Gewebe nach Anspruch 9,
**dadurch gekennzeichnet,**
**dass** der Teil mit eindringendem Profil der Kappe (9) pyramidenförmig gestaltet ist.

11. Gewebe nach Anspruch 9,
**dadurch gekennzeichnet,**
**dass** der Teil mit eindringendem Profil der Kappe (9) konusförmig gestaltet ist.

12. Gewebe nach Anspruch 11,
**dadurch gekennzeichnet,**
**dass** der Konus ein Außengewinde mit zwei Gewindegängen aufweist, wobei jeder Gewindegang in eine der Rillen (4a, 4b) mündet.

13. Gewebe nach Anspruch 8,
**dadurch gekennzeichnet,**
**dass** der elektronische Chip (8) eine Elektrolumineszenz-Diode aufweist.

14. Gewebe nach Anspruch 7,
**dadurch gekennzeichnet,**
**dass** die Vorrichtung vier Rillen (4a - 4d) aufweist, die im Rechteck angeordnet sind und in die vier Fäden eingesetzt sind, die eine Masche des Gewebes bilden.

## Claims

1. Method for assembling a device on two threads comprising the following steps:
• providing two substantially parallel taut threads (12);
• providing a device comprising an electronic chip (8) and two substantially parallel grooves (4a, 4b) open on opposite sides of the device, the distance separating the grooves corresponding to the distance separating the threads, said device comprising a part with a penetrating profile extending along an axis perpendicular to the plane of the grooves, said part with a penetrating profile having a base at the level of the grooves and an apex (1) of smaller dimension than the distance separating the threads;
• placing said apex (1) of the device between the two threads;
• moving the device between the two threads resulting in the threads being separated from one another by said part with a penetrating profile; and
• continuing to move the device until said threads enter the grooves reverting to their initial separating distance.

2. Method according to claim 1, **characterized in that** the part with a penetrating profile of the device is conical and comprises a threading with two threads (20) each opening into a respective groove (4a, 4b), the method comprising the following steps:
• placing the threaded parts in contact with the two threads; and
• applying a tightening movement to the device.

3. Method according to claim 1, **characterized in that** a groove of the device comprises a bump (6a, 6b) for performing electric connection (4a, 4b), the thread corresponding to the groove provided with the bump being electrically conducting.

4. Method according to claim 1, **characterized in that** the device comprises a cover (9) delineating the grooves (4a, 4b), in conjunction with the electronic chip (8), said cover including said part with a penetrating profile.

5. Method according to claim 4, **characterized in that** the part with a penetrating profile of the cover (9) is in the shape of a pyramid.

6. Method according to claim 4, **characterized in that** the part with a penetrating profile of the cover (9) is in the shape of a cone.

7. Fabric (12, 13) including a device comprising an electronic chip (8) and two substantially parallel grooves (4a, 4b) open on opposite sides of the device, in each of which one thread of the fabric is inserted, the two threads inserted in said grooves being two consecutive threads substantially parallel to the fabric, the fabric being **characterized in that** the device comprises a part with a penetrating profile which extends along an axis perpendicular to the plane of the grooves and which presents a base at the level of the grooves and an apex (1) of smaller dimension than the distance separating the threads.

8. Fabric according to claim 7, **characterized in that** a groove of the device comprises a bump (6a, 6b) for performing electric connection (4a, 4b), the thread inserted in the groove provided with the bump being electrically conducting and in electric contact with said bump.

9. Fabric according to claim 7, **characterized in that** the device comprises a cover (9) delineating the grooves (4a, 4b), in conjunction with the electronic chip (8), said cover including said part with a penetrating profile.

10. Fabric according to claim 9, **characterized in that** the part with a penetrating profile of the cover (9) is in the shape of a pyramid.

11. Fabric according to claim 9, **characterized in that** the part with a penetrating profile of the cover (9) is in the shape of a cone.

12. Fabric according to claim 11, **characterized in that** the cone comprises a threading with two threads, each thread opening into one of the grooves (4a, 4b).

13. Fabric according to claim 8, **characterized in that** the electronic chip (8) comprises a light-emitting diode.

14. Fabric according to claim 7, **characterized in that** the device comprises four grooves (4a-4d) arranged to form a rectangle, four threads forming a stitch of the fabric being inserted in the grooves.
